(19) Europäisches Patentamt

European Patent Office

Office européen des brevets

(11) **EP 2 897 280 B1**

(12) **EUROPEAN PATENT SPECIFICATION**

(45) Date of publication and mention
of the grant of the patent:
**14.11.2018 Bulletin 2018/46**

(51) Int Cl.:
*H02M 7/487* (2007.01)          *H02P 27/14* (2006.01)
*H02P 21/00* (2016.01)

(21) Application number: **14151422.4**

(22) Date of filing: **16.01.2014**

(54) **Method and device for estimating power and/or current of inverter**

Verfahren und Vorrichtung zur Schätzung der Leistung und/oder des Stroms eines Wechselrichters

Procédé et dispositif d'estimation de la puissance et/ou de courant d'onduleur

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**22.07.2015 Bulletin 2015/30**

(73) Proprietor: **ABB Schweiz AG
5400 Baden (CH)**

(72) Inventor: **Heikkilä, Samuli
00380 Helsinki (FI)**

(74) Representative: **Kolster Oy Ab
(Salmisaarenaukio 1)
P.O. Box 204
00181 Helsinki (FI)**

(56) References cited:
**WO-A1-2011/048457     JP-A- 2009 201 248**

**Description**

FIELD OF THE INVENTION

The present invention relates to estimation methods, and more particularly to estimating an active and/or reactive component of output power or current of an inverter.

BACKGROUND INFORMATION

Controlling an inverter may require information on output current or output power. For example, a direct component and a quadrature component of an output current may be used when controlling torque and flux of an electric machine. In this context, the direct and quadrature components refer to components of a coordinate system rotating synchronously with a fundamental frequency component of an output voltage. In the present disclosure, the synchronously rotating coordinate system is referred to as a *dq*-coordinate system. The direct component is in phase with the fundamental frequency component of the output voltage. The quadrature component has a 90 degree phase shift to the fundamental frequency component of the output voltage. Components of the output power in *dq* coordinates may be required for determining the power factor of the produced power, for example. In the present disclosure, the direct component of the output power may also be referred to as the active component. Correspondingly, the quadrature component may be referred to as the reactive component.

Determining the output current may require current sensors, such as current transducers, for measuring the current. The current sensors may be expensive and increase the costs of the system. Information on the output current may be required even when estimating output power, since output power is typically calculated from the output voltage and the output current.

Japanese patent application JP 20092011248 A relates to power conversion apparatus. PCT patent application WO 2011/048457 A1 relates to a system for offsetting the input voltage unbalance in multilevel inverters.

BRIEF DISCLOSURE

An object of the present invention is to provide a method and a device for implementing the method so as to alleviate the above disadvantages. The objects of the invention are achieved by a method and a device which are characterized by what is stated in the independent claims. Preferred embodiments of the invention are disclosed in the dependent claims.

The present disclosure describes a method for estimating an active (i.e. direct) and/or reactive (i.e. quadrature) component of output power of a three-level inverter comprising a DC link divided into two halves by a neutral point (NP). The method is based on determining components of a third harmonic present in the voltage of the neutral point. The components of the output power may be estimated on the basis of the determined third harmonic components.

The third harmonic components, and thereby the components of the output power, may be estimated by using only DC link voltage measurements, e.g. the DC link voltage and NP voltage potential (or voltages over the halves of the DC link). Thus, the method does not require current transducers.

The method may be used for controlling the output power directly without using any current measurements. The method may also be used for correcting estimation errors in power estimates of conventional methods, thereby enabling the use of cheaper current sensors.

Further, the method may also be used for estimating direct and quadrature components of the output current. The current components may be used for determining the flux orientation angle of an electrical machine, for example. The current components and the orientation angle may be used to control the torque and flux of the machine directly, for example. The method may also be used for improving the accuracy of a conventional flux observer based on torque and flux control.

BRIEF DESCRIPTION OF THE DRAWINGS

In the following, the invention will be described in greater detail by means of the preferred embodiments with reference to the attached drawing, in which

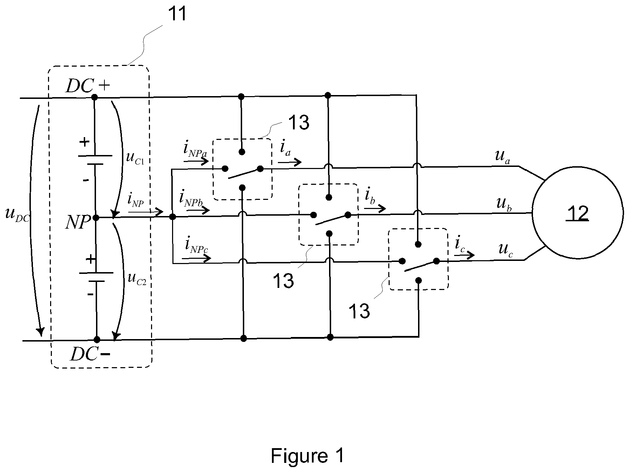

Figure 1 illustrates a simplified concept of a three-phase, three-level inverter supplying a load.

DETAILED DISCLOSURE

The present disclosure describes a method for an inverter comprising a DC link which is divided into two halves by a neutral point. The inverter may be a three-level, three-phase inverter, for example. The DC link may incorporate two capacitors connected in series so that output phases are switched either to DC+, DC- or neutral point (NP) of the DC link, for example.

Further, the present disclosure describes a device comprising means configured to implement the method of the present disclosure.

The method and the device may be used for estimating an active (i.e. direct) and/or reactive (i.e. quadrature) component of output power of the inverter, for example. The power quantities may be estimated by using only DC link voltage measurements, e.g. the DC link voltage and NP potential (or voltages over the DC link capacitors).

With the DC link voltage measurements, the method may determine a voltage ripple at the neutral point. A magnitude of a third harmonic component of the voltage ripple may then be determined in *dq* coordinates, i.e. in a rotating coordinate system that rotates synchronously with an output voltage of the inverter. The active and/or reactive component of an output power in the rotating coordinate system may be calculated on the basis of the magnitude of the third harmonic component.

As the power is estimated on the basis of DC link voltage measurements, the method may be implemented without current transducers. Thus, it may be used as an alternative to the conventional methods where the inverter output power is estimated based on measured phase currents and voltages, for example.

The method of the present disclosure may also be used for estimating a direct and/or quadrature component of output current of the inverter. Thus, the method may be for determining a flux orientation angle of an electrical machine, for example. The components of the current and the orientation angle may be used for directly controlling torque and flux of the machine.

Even when direct measurement of current is required (e.g. by using a DC shunt or by measuring phase currents) in order to ensure operation of circuit protections, for example, the method and device of the disclosure may be used for improving the accuracy of measurements. Thus, less accurate (and therefore less costly) current sensors may be used. Correspondingly, the method may also be used for improving the accuracy of a conventional flux-observer-based torque and flux control.

The method of the present disclosure utilises analysis of a third harmonic of the NP voltage. The third harmonic typically increases with power taken from the DC link. The method assumes that the common-mode voltage is held at zero level, output voltage and frequency are constant and the load is in steady state.

Under these assumptions, a set of steady state equations for an NP current $i_{NP}$ may be formed. The steady state equations may then be used for calculating third harmonic components of the NP voltage, and consequently the relationship between those components and the output power. The formulation of the steady state equations will be discussed next in more detail and with reference to an exemplary embodiment.

Figure 1 shows a simplified concept of a three-phase, three-level inverter supplying a load 12. The inverter comprises a DC link 11 that is divided into two halves by a neutral point *NP*. In Figure 1, the DC link halves are formed by two capacitances in the form of capacitors $C_1$ and $C_2$ with voltages $u_{C1}$ and $u_{C2}$ over them. Voltage $u_{DC}$ represents the voltage over the whole DC link. Each of the output phases supplying the load 12 can be connected to a positive pole *DC+*, a negative pole *DC-* or the neutral point of the DC link 11 by using switching means 13.

The load 12 is supplied with phase currents $i_a$, $i_b$, and $i_c$ and phase voltages $u_a$, $u_b$, and $u_c$ in Figure 1. A neutral point current $i_{NP}$ flows from the neutral point *NP*. The neutral point current $i_{NP}$ is divided into neutral point current phase components $i_{NPa}$, $i_{NPb}$, and $i_{NPc}$ that flow through corresponding switching means 13.

The phase voltages $u_a$, $u_b$, and $u_c$ and phase currents $i_a$, $i_b$, and $i_c$ are assumed sinusoidal and oscillating at a fundamental frequency $\omega$. The phase voltages $u_a$, $u_b$, and $u_c$ have a constant voltage amplitude $U_{AMP}$ while the phase currents $i_a$, $i_b$, and $i_c$ have a constant current amplitude $I_{AMP}$. Thus, the phase voltages and currents may be defined in the following manner:

$$\begin{cases} u_a = U_{AMP}\cos(\omega t), \\ u_b = U_{AMP}\cos(\omega t - 2\pi/3), \\ u_c = U_{AMP}\cos(\omega t - 4\pi/3), \end{cases} \tag{1}$$

$$\begin{cases} i_a = I_{AMP}\cos(\omega t - \varphi), \\ i_b = I_{AMP}\cos(\omega t - \varphi - 2\pi/3), \\ i_c = I_{AMP}\cos(\omega t - \varphi - 4\pi/3), \end{cases} \tag{2}$$

where $\varphi$ is a phase shift between phase voltages $u_a$, $u_b$, and $u_c$ and phase currents $i_a$, $i_b$, and $i_c$ so that $\varphi > 0$ for inductive loads.

An NP voltage $u_{NP}$ may be considered to be a voltage potential of the neutral point with respect to a virtual mid-point voltage potential between the poles of the DC link. Thus, the NP voltage $u_{NP}$ may be considered to represent the balance of the DC link. On average, the NP voltage $u_{NP}$ is assumed to be in balance so that $u_{C1} = u_{C2} = U_{DC}/2$. The ripple of the NP voltage $u_{NP}$ is assumed to be small compared with the DC link voltage $U_{DC}$.

The instantaneous NP current $i_{NP}$ may be calculated as the sum of the neutral point current phase components $i_{NPa}$, $i_{NPb}$, and $i_{NPc}$. Equations for the phase components $i_{NPa}$, $i_{NPb}$, and $i_{NPc}$ may be derived from the phase currents, the phase voltages, and the DC link voltage. For example, an NP current phase component $i_{NPa}$ of phase $a$ is proportional to the phase current $i_a$ and phase voltage $u_a$ so that

$$i_{NPa} = \left(1 - \frac{|u_a|}{U_{DC}/2}\right) i_a \ . \tag{3}$$

In Equation (3), $i_{NPa}$ equals $i_a$ when $u_a = 0$ (i.e. phase $a$ is continuously connected to NP), and decreases linearly as the magnitude $u_a$ increases. At voltage level $u_a = \pm U_{DC}/2$, phase $a$ is continuously connected to one of the DC link poles and, thus, $i_{NPa} = 0$.

Substituting Equations (1) and (2) into Equation (3) yields

$$i_{NPa} = \left(1 - \frac{U_{AMP}}{U_{DC}/2}|\cos(\omega t)|\right) I_{AMP} \cos(\omega t - \varphi)$$

$$= I_{AMP}\left(1 - 2\frac{U_{AMP}}{U_{DC}}|\cos(\omega t)|\right)\left(\cos(\omega t)\cos(\varphi) + \sin(\omega t)\sin(\varphi)\right). \tag{4}$$

A real part of the third harmonic ($Re_{3h}$) of the component $i_{NPa}$ may be calculated as follows ($\omega t \to x$)

$$\text{Re}_{3h}\{i_{NPa}\} = \frac{1}{\pi}\int_{-\pi}^{\pi} i_{NPa}(x)\cos 3x\, dx =$$
$$-2I_{AMP}\frac{U_{AMP}}{U_{DC}}\left(CC\cos(\varphi) + SC\sin(\varphi)\right), \tag{5}$$

where

$$\begin{cases} CC = \dfrac{1}{\pi}\displaystyle\int_{-\pi}^{\pi} |\cos x|\cos x\cos 3x\, dx, \\[2ex] SC = \dfrac{1}{\pi}\displaystyle\int_{-\pi}^{\pi} |\cos x|\sin x\cos 3x\, dx = 0. \end{cases}$$

Calculation of the definite integral CC gives:

$$CC = \frac{1}{\pi} \int_{-\pi}^{\pi} |\cos x| \cos x \cos 3x \, dx$$

$$= \frac{2}{\pi} \int_{-\pi/2}^{\pi/2} \cos^2 x \cos 3x \, dx$$

$$= \frac{2}{\pi} \int_{-\pi/2}^{\pi/2} \cos^2 x \left(4 \cos^3 x - 3 \cos x\right) dx$$

$$= \frac{2}{\pi} \int_{-\pi/2}^{\pi/2} \left(4\left(1 - \sin^2 x\right)^2 \cos x - 3\left(1 - \sin^2 x\right)\cos x\right) dx$$

$$= \frac{2}{\pi} \Big|_{-\pi/2}^{\pi/2} \left(4\left(\sin x - \frac{2}{3}\sin^3 x + \frac{1}{5}\sin^5 x\right) - 3\left(\sin x - \frac{1}{3}\sin^3 x\right)\right) = \frac{8}{15\pi}.$$

*SC* is a definite integral of an odd function from $-\pi$ to $\pi$ and is therefore zero:

$$\begin{cases} CC = \dfrac{8}{15\pi}, \\ SC = 0. \end{cases} \tag{6}$$

Substituting Equation (6) into Equation (5) gives the real part of the third harmonic of $i_{NPa}$:

$$\mathrm{Re}_{3h}\{i_{NPa}\} = -2I_{AMP} \frac{U_{AMP}}{U_{DC}} \frac{8}{15\pi} \cos(\varphi) \tag{7}$$

Since the phase currents $i_a$, $i_b$, and $i_c$ have a $2\pi/3$ phase shift between each other (i.e. $i_b(t) = i_a(t - 2\pi/(3\omega))$, $i_c(t) = i_a(t - 4\pi/(3\omega))$)) and the phase voltages $u_a$, $u_b$, and $u_c$ have a $2\pi/3$ phase shift between each other (i.e. $u_b(t) = u_a(t - 2\pi/(3\omega))$, and $u_c(t) = u_a(t - 4\pi/(3\omega))$)), the calculation of the real part of the third harmonic of phase currents $i_{NPb}$ and $i_{NPc}$ yields the same coefficients as in Equation (7). Therefore:

$$\mathrm{Re}_{3h}\{i_{NPa}\} = \mathrm{Re}_{3h}\{i_{NPb}\} = \mathrm{Re}_{3h}\{i_{NPc}\} = -M \frac{8}{15\pi} I_d , \tag{8}$$

where

$$\begin{cases} M = \dfrac{U_{AMP}}{U_{DC}/2}, \\ I_d = I_{AMP} \cos(\varphi). \end{cases}$$

Coefficient $M$ represents the modulation index while $I_d$ represents a direct component of the output current at the fundamental frequency of the output voltage.

The real part of the third harmonic of the NP current $i_{NP}$ is the sum of the real parts of the third harmonics of the neutral point current phase components $i_{NPa}$, $iNP_b$, and $i_{NPc}$:

$$\Rightarrow \mathrm{Re}_{3h}\{i_{NP}\} = \mathrm{Re}_{3h}\{i_{NPa}\} + \mathrm{Re}_{3h}\{i_{NPb}\} + \mathrm{Re}_{3h}\{i_{NPc}\} = -M \frac{8}{5\pi} I_d . \tag{9}$$

Correspondingly, an imaginary part of the third harmonic ($\mathrm{Im}_{3h}$) of $i_{NPa}$ may be calculated followingly:

$$\text{Im}_{3h}\{i_{NPa}\} = \frac{1}{\pi}\int_{-\pi}^{\pi} i_{NPa}(x)\sin 3x\,dx =$$

$$-2I_{AMP}\frac{U_{AMP}}{U_{DC}}\big(CS\cos(\varphi) + SS\sin(\varphi)\big), \tag{10}$$

where

$$\begin{cases} CS = \dfrac{1}{\pi}\displaystyle\int_{-\pi}^{\pi} |\cos x|\cos x\sin 3x\,dx = 0, \\[2ex] SS = \dfrac{1}{\pi}\displaystyle\int_{-\pi}^{\pi} |\cos x|\sin x\sin 3x\,dx. \end{cases}$$

Again, a definite integral of an odd function from $-\pi$ to $\pi$ is zero and, thus, $CS = 0$. The calculation of the definite integral $SS$ yields:

$$\begin{aligned} SS &= \frac{1}{\pi}\int_{-\pi}^{\pi} |\cos x|\sin x\sin 3x\,dx \\[1.5ex] &= \frac{2}{\pi}\int_{-\pi/2}^{\pi/2} \cos x\sin x\sin 3x\,dx \\[1.5ex] &= \frac{2}{\pi}\int_{-\pi/2}^{\pi/2} \cos x\sin x\big(3\sin x - 4\sin^3 x\big)\,dx \\[1.5ex] &= \frac{2}{\pi}\int_{-\pi/2}^{\pi/2} \big(3\sin^2 x - 4\sin^4 x\big)\cos x\,dx = \\[1.5ex] &\quad \frac{2}{\pi}\Big|_{-\pi/2}^{\pi/2}\left(\sin^3 x - \frac{4}{5}\sin^5 x\right) = \frac{4}{\pi}\left(1 - \frac{4}{5}\right) = \frac{4}{5\pi}. \end{aligned}$$

Thus, the imaginary part of the third harmonic of the NP current phase component $i_{NPa}$ presented in Equation (10) may be simplified:

$$\text{Im}_{3h}\{i_{NPa}\} = -I_{AMP}M\frac{4}{5\pi}\sin(\varphi). \tag{11}$$

Similarly to the real parts of phases b and c, the calculation of the imaginary parts of phases b and c yields the same coefficients as in Equation (11), and, therefore:

$$\text{Im}_{3h}\{i_{NP}\} = 3\,\text{Im}_{3h}\{i_{NPa}\} = -M\frac{12}{5\pi}I_q, \tag{12}$$

where a quadrature component $I_q$ of the current (at the fundamental frequency) may be defined as follows:

$$I_q = I_{AMP}\sin(\varphi). \tag{13}$$

Thus, the direct component $I_d$ and the quadrature component $I_q$ of the current at the fundamental frequency may be calculated based on the third harmonic of the NP current $i_{NP}$ as follows:

$$\begin{cases} I_d = -\dfrac{5\pi}{8M} \operatorname{Re}_{3h}\{i_{NP}\}, \\ I_q = -\dfrac{5\pi}{12M} \operatorname{Im}_{3h}\{i_{NP}\}. \end{cases} \tag{14}$$

Correspondingly, an active power component $P$ and a reactive power component $Q$ of the three phase system may be calculated as follows:

$$\begin{cases} P = \dfrac{3}{2} U_{AMP} I_d = -\dfrac{15\pi}{32} U_{DC} \operatorname{Re}_{3h}\{i_{NP}\}, \\ Q = \dfrac{3}{2} U_{AMP} I_q = -\dfrac{5\pi}{16} U_{DC} \operatorname{Im}_{3h}\{i_{NP}\}. \end{cases} \tag{15}$$

A relationship between the NP current and voltage at the third harmonic frequency may be utilised in order to calculate these current and power components on the basis of the third harmonic present in the ripple of the NP voltage $u_{NP}$. For example in Figure 1, an NP terminal impedance corresponds to parallel connected capacitances $C_1$ and $C_2$, which means that

$$\begin{cases} \operatorname{Re}_{3h}\{i_{NP}\} = -3\omega(C_1 + C_2) \operatorname{Im}_{3h}\{u_{NP}\}, \\ \operatorname{Im}_{3h}\{i_{NP}\} = 3\omega(C_1 + C_2) \operatorname{Re}_{3h}\{u_{NP}\}. \end{cases} \tag{16}$$

The method of the present disclosure may comprise determining the ripple in the NP voltage $u_{NP}$ and determining a magnitude of a real and/or imaginary component of the third harmonic of the ripple in a rotating coordinate system that rotates synchronously with an output voltage of the inverter. A component or components of an output current or power in the rotating coordinate system may then be calculated on the basis of the magnitude of the third harmonic component(s).

In order to determine the voltage ripple, voltages over the halves of the DC link may be measured, and the voltage ripple may be calculated on the basis of a difference between the measured voltages. For example, in Figure 1, the ripple of the NP voltage $u_{NP}$ may be calculated as a difference between the lower capacitor voltage $u_{C2}$ and the upper capacitor voltage $u_{C1}$:

$$u_{NP} = (u_{C2} - u_{C1})/2, \tag{17}$$

so that Equation (16) becomes

$$\begin{cases} \operatorname{Re}_{3h}\{i_{NP}\} = -\dfrac{3}{2}\omega(C_1 + C_2) \operatorname{Im}_{3h}\{u_{C2} - u_{C1}\}, \\ \operatorname{Im}_{3h}\{i_{NP}\} = \dfrac{3}{2}\omega(C_1 + C_2) \operatorname{Re}_{3h}\{u_{C2} - u_{C1}\}. \end{cases} \tag{18}$$

Substituting Equation (18) into Equations (14) and (15) leads to

$$\begin{cases} I_d = \dfrac{15\pi}{16M}\omega\left(C_1 + C_2\right)\mathrm{Im}_{3h}\left\{u_{C2} - u_{C1}\right\}, \\[3mm] I_q = -\dfrac{5\pi}{8M}\omega\left(C_1 + C_2\right)\mathrm{Re}_{3h}\left\{u_{C2} - u_{C1}\right\}. \end{cases} \qquad (19)$$

$$\begin{cases} P = \dfrac{45\pi}{64}U_{DC}\omega\left(C_1 + C_2\right)\mathrm{Im}_{3h}\left\{u_{C2} - u_{C1}\right\}, \\[3mm] Q = -\dfrac{15\pi}{32}U_{DC}\omega\left(C_1 + C_2\right)\mathrm{Re}_{3h}\left\{u_{C2} - u_{C1}\right\}. \end{cases} \qquad (20)$$

As shown in Equations (19) and (20), the DC voltages $u_{C1}$ and $u_{C2}$ and the third harmonic of the NP voltage carry the information required for calculating direct and quadrature current and power components at the fundamental frequency.

A direct component (e.g. $P$ or $I_d$) of an output current or power in the synchronously rotating coordinate system may be estimated by determining a magnitude of a quadrature third harmonic component of the voltage ripple in the rotating coordinate system, and then by calculating the direct component ($P$ or $I_d$) of the output current or power on the basis of the magnitude of the quadrature third harmonic component.

In a similar manner, a quadrature component (e.g. $Q$ or $I_q$) of an output current or power in the synchronously rotating coordinate system may be estimated by determining a magnitude of a direct third harmonic component of the voltage ripple in the rotating coordinate system, and then by calculating the quadrature component ($Q$ or $I_q$) of the output current or power on the basis of the magnitude of the direct third harmonic component.

The method of the present disclosure may be implemented on a control unit of an inverter, for example. The control unit may be a CPU, a DSP, an FPGA, or an ASIC, for example. The inverter, or its control unit, may be configured to determine a voltage ripple at the neutral point, determine a magnitude of a third harmonic component of the volt-age ripple in a rotating coordinate system that rotates synchronously to an output voltage of the inverter, and calculate a component of an output current or power in the rotating coordinate system on the basis of the magnitude of the third harmonic component. Control of an inverter typically requires information about the fundamental frequency and modulation index, so these parameters may be already available on the inverter. However, a device implementing the method of the present disclosure may also be a separate device.

The method may also use the capacitance values of capacitors $C_1$ and $C_2$, which means that the current and power estimation accuracy may be directly proportional to the accuracy of these capacitances. However, the parameter accuracy only affects the magnitude of the estimated quantities so that, for example, the phase shift $\varphi$ between voltage and current is completely unaffected by parameter errors when estimating it on the basis of Equation (19):

$$\tan\varphi = \frac{I_q}{I_d} = -\frac{2}{3}\frac{\mathrm{Re}_{3h}\left\{u_{C2} - u_{C1}\right\}}{\mathrm{Im}_{3h}\left\{u_{C2} - u_{C1}\right\}}, \qquad (21)$$

whereas the magnitude of the current estimate $\hat{I}_{AMP}$ depends on the said parameters:

$$\hat{I}_{AMP} = \frac{5\pi}{8M}\omega\left(C_1 + C_2\right)\sqrt{\mathrm{Re}_{3h}\left\{u_{C2} - u_{C1}\right\}^2 + \frac{9}{4}\mathrm{Im}_{3h}\left\{u_{C2} - u_{C1}\right\}^2}. \qquad (22)$$

It will be obvious to a person skilled in the art that the inventive concept can be implemented in various ways. The invention and its embodiments are not limited to the examples described above but may vary within the scope of the claims.

**Claims**

1. A method for a three-level inverter comprising a DC link divided into two halves by a neutral point, wherein the method comprises

determining a voltage ripple at the neutral point,
**characterized in that** the method further comprises
determining an imaginary part of a third harmonic component ($\text{Im}_{3h}$) of the voltage ripple in a rotating coordinate system that rotates synchronously with an output voltage of the inverter,
calculating a direct component of an output current in the rotating coordinate system, wherein the result of the calculation represents a product of the imaginary part of the third harmonic component ($\text{Im}_{3h}$), a sum ($C_1 + C_2$) of capacitances forming the DC link halves, a fundamental frequency ($\omega$) of the output voltage, a reciprocal of the modulation index ($M$) of the inverter, and a constant ($15\pi/8$).

2. A method according to claim 1, wherein the direct component of the output current is calculated by using the equation:

$$I_d = \frac{15\pi}{16M} \omega \left( C_1 + C_2 \right) \text{Im}_{3h} \left\{ u_{C2} - u_{C1} \right\},$$

wherein $\omega$ is the fundamental frequency of the output voltage, M is the modulation index, $C_1$ and $C_2$ are the capacitances forming the DC link halves, $\text{Im}_{3h}$ is a function for the imaginary part of the third harmonic, and the voltage ripple at neutral point is $(u_{C2} - u_{C1})/2$, wherein $u_{C1}$ and $u_{C2}$ are the voltages over the capacitances..

3. A method for a three-level inverter comprising a DC link divided into two halves by a neutral point, wherein the method comprises
determining a voltage ripple at the neutral point,
**characterized in that** the method further comprises
determining an imaginary part ($\text{Im}_{3h}$) of a third harmonic component of the voltage ripple in a rotating coordinate system that rotates synchronously with an output voltage of the inverter,
calculating a direct component of an output power in the rotating coordinate system, wherein the result of the calculation represents a product of the imaginary part of the third harmonic component ($\text{Im}_{3h}$), a sum ($C_1 + C_2$) of capacitances forming the DC link halves, a fundamental frequency ($\omega$) of the output voltage, a DC link voltage ($U_{DC}$), and a constant ($45\pi/32$).

4. A method according to claim 3, wherein a direct component of the output power is calculated by using the equation:

$$P = \frac{45\pi}{64} U_{DC} \omega \left( C_1 + C_2 \right) \text{Im}_{3h} \left\{ u_{C2} - u_{C1} \right\},$$

wherein $U_{DC}$ is the DC link voltage, $\omega$ is the fundamental frequency of the output voltage, $C_1$ and $C_2$ are the capacitances forming the DC link halves, $\text{Im}_{3h}$ is a function for the imaginary part of the third harmonic, and the voltage ripple at neutral point is $(u_{C2} - u_{C1})/2$, wherein $u_{C1}$ and $u_{C2}$ are voltages over the capacitances..

5. A method for a three-level inverter comprising a DC link divided into two halves by a neutral point, wherein the method comprises
determining a voltage ripple at the neutral point,
**characterized in that** the method further comprises
determining a real part ($\text{Re}_{3h}$) of a third harmonic component of the voltage ripple in a rotating coordinate system that rotates synchronously with an output voltage of the inverter,
calculating a quadrature component of an output current in the rotating coordinate system, wherein the result of the calculation represents a product of the real part of the third harmonic component, a sum ($C_1 + C_2$) of capacitances forming the DC link halves, a fundamental frequency ($\omega$) of the output voltage, a reciprocal of the modulation index ($M$) of the inverter, and a constant ($-5\pi/4$).

6. A method according to claim 5, wherein the quadrature component of the output current is calculated by using the equation:

$$I_q = -\frac{5\pi}{8M} \omega \left( C_1 + C_2 \right) \text{Re}_{3h} \left\{ u_{C2} - u_{C1} \right\},$$

wherein $\omega$ is the fundamental frequency of the output voltage, $M$ is the modulation index, $C_1$ and $C_2$ are the capacitances forming the DC link halves, $\text{Re}_{3h}$ is a function for the real part of the third harmonic, and the voltage ripple at neutral point is $(u_{C2} - u_{C1})/2$, wherein $u_{C1}$ and $u_{C2}$ are voltages over the capacitances..

7. A method for a three-level inverter comprising a DC link divided into two halves by a neutral point, wherein the method comprises

determining a voltage ripple at the neutral point,

**characterized in that** the method further comprises

determining a real part ($\text{Re}_{3h}$) of a third harmonic component of the voltage ripple in a rotating coordinate system that rotates synchronously with an output voltage of the inverter,

calculating a quadrature component of an output power in the rotating coordinate system, wherein the result of the calculation represents a product of the real part of the third harmonic component, a sum ($C_1 + C_2$) of capacitances forming the DC link halves, a fundamental frequency ($\omega$) of the output voltage, a DC link voltage ($U_{DC}$), and a constant ($-15\pi/16$).

8. A method according to claim 7, wherein a quadrature component of the output power is calculated by using the equation:

$$Q = -\frac{15\pi}{32} U_{DC}\omega\left(C_1 + C_2\right)\text{Re}_{3h}\left\{u_{C2} - u_{C1}\right\},$$

wherein $U_{DC}$ is the DC link voltage, $\omega$ is the fundamental frequency of the output voltage, $C_1$ and $C_2$ are capacitances forming the DC link halves, $\text{Re}_{3h}$ is a function for the real part of the third harmonic, and the voltage ripple at neutral point is $(u_{C2} - u_{C1})/2$, wherein $u_{C1}$ and $u_{C2}$ are the voltages over the capacitances..

9. A device for a three-level inverter comprising a DC link which is divided into two halves by a neutral point, wherein the device comprises means for carrying out the method according to any one of claims 1, 3, 5 or 7

10. An inverter comprising a device according to claim 8.

**Patentansprüche**

1. Verfahren für einen Drei-Pegel-Wechselrichter mit einem DC-Zwischenkreis, der durch einen Neutralpunkt in zwei Hälften geteilt ist, wobei das Verfahren umfasst

Ermitteln eines Spannungsrippels an dem Neutralpunkt,

**dadurch gekennzeichnet, dass** das Verfahren ferner umfasst

Ermitteln eines Imaginärteils einer dritten harmonischen Komponente ($\text{Im}_{3h}$) des Spannungsrippels in einem rotierenden Koordinatensystem, das synchron mit einer Ausgangsspannung des Wechselrichters rotiert,

Berechnen einer Gleichstromkomponente des Ausgangsstroms in dem rotierenden Koordinatensystem, wobei das Ergebnis der Berechnung ein Produkt des Imaginärteils der dritten harmonischen Komponente ($\text{Im}_{3h}$), einer Summe ($C_1 + C_2$) von Kapazitäten, die die DC-Zwischenkreishälften bilden, einer Grundfrequenz ($\omega$) der Ausgangsspannung, eines Kehrwerts des Modulationsindex ($M$) des Wechselrichters und einer Konstanten ($15\pi/8$) repräsentiert.

2. Verfahren nach Anspruch 1, wobei die Gleichstromkomponente des Ausgangsstroms unter Anwendung der Gleichung berechnet wird:

$$I_d = \frac{15\pi}{16M}\omega\left(C_1 + C_2\right)\text{Im}_{3h}\left\{u_{C2} - u_{C1}\right\},$$

wobei $\omega$ die Grundfrequenz der Ausgangsspannung ist, $M$ der Modulationsindex ist, $C_1$ und $C_2$ die Kapazitäten sind, die die DC-Zwischenkreishälften bilden, $\text{Im}_{3h}$ eine Funktion des Imaginärteils der dritten Harmonischen ist und der Spannungsrippel an dem Neutralpunkt $(u_{C2} - u_{C1})/2$ ist, wobei $u_{C1}$ und $u_{C2}$ die Spannungen an den Kapazitäten sind.

3. Verfahren für einen Drei-Pegel-Wechselrichter mit einem DC-Zwischenkreis, der durch einen Neutralpunkt in zwei Hälften geteilt ist, wobei das Verfahren umfasst
Ermitteln eines Spannungsrippels an dem Neutralpunkt,
**dadurch gekennzeichnet, dass** das Verfahren ferner umfasst
Ermitteln eines Imaginärteils ($Im_{3h}$) einer dritten harmonischen Komponente des Spannungsrippels in einem rotierenden Koordinatensystem, das synchron mit einer Ausgangsspannung des Wechselrichters rotiert,
Berechnen einer Gleichstromkomponente einer Ausgangsleistung in dem rotierenden Koordinatensystem, wobei das Ergebnis der Berechnung ein Produkt des Imaginärteils der dritten harmonischen Komponente ($Im_{3h}$), einer Summe ($C_1 + C_2$) der die DC-Zwischenkreishälften bildenden Kapazitäten, einer Grundfrequenz ($\omega$) der Ausgangsspannung, einer DC-Zwischenkreisspannung ($U_{DC}$) und einer Konstanten ($45\pi/32$) ist.

4.  Verfahren nach Anspruch 3, wobei eine Gleichstromkomponente der Ausgangsleistung berechnet wird unter Anwendung der Gleichung:

$$P = \frac{45\pi}{64} U_{DC}\,\omega\left(C_1 + C_2\right)\mathrm{Im}_{3h}\left\{u_{C2} - u_{C1}\right\},$$

wobei $U_{DC}$ die DC-Zwischenkreisspannung ist, $\omega$ die Grundfrequenz der Ausgangsspannung ist, $C_1$ und $C_2$ die die DC-Zwischenkreishälften bildenden Kapazitäten sind, $Im_{3h}$ eine Funktion für den Imaginärteil der dritten Harmonischen ist und der Spannungsrippel am Neutralpunkt ($u_{C2}$ - $u_{C1}$)/2 ist, wobei $u_{C1}$ und $u_{C2}$ die Spannungen an den Kapazitäten sind.

5.  Verfahren für einen Drei-Pegel-Wechselrichter, mit einem DC-Zwischenkreis, der durch einen Neutralpunkt in zwei Hälften geteilt ist, wobei das Verfahren umfasst
Ermitteln eines Spannungsrippels an dem Neutralpunkt,
**dadurch gekennzeichnet, dass** das Verfahren ferner umfasst
Ermitteln eines Realteils ($Re_{3h}$) einer dritten harmonischen Komponente des Spannungsrippels in einem rotierenden Koordinatensystem, das synchron mit einer Ausgangsspannung des Wechselrichters rotiert,
Berechnen einer Quadraturkomponente eines Ausgangsstroms in dem rotierenden Koordinatensystem, wobei das Ergebnis der Berechnung ein Produkt des Realteils der dritten harmonischen Komponente, einer Summe ($C_1 + C_2$) der die DC-Zwischenkreishälften bildenden Kapazitäten, einer Grundfrequenz ($\omega$) der Ausgangsspannung, eines Kehrwerts des Modulationsindex (M) des Wechselrichters und einer Konstanten ($-5\pi/4$) repräsentiert.

6.  Verfahren nach Anspruch 5, wobei die Quadraturkomponente des Ausgangsstroms unter Verwendung der Gleichung berechnet wird:

$$I_q = -\frac{5\pi}{8M}\,\omega\left(C_1 + C_2\right)\mathrm{Re}_{3h}\left\{u_{C2} - u_{C1}\right\},$$

wobei $\omega$ die Grundfrequenz der Ausgangsspannung ist, M der Modulationsindex ist, $C_1$ und $C_2$ die die DC-Zwischenkreishälften bildenden Kapazitäten sind, $Re_{3h}$ eine Funktion für den Realteil der dritten Harmonischen ist, und der Spannungsrippel am Neutralpunkt ($u_{C2}$ - uci)/2 ist, wobei $u_{C1}$ und $u_{C2}$ die Spannungen an den Kapazitäten sind.

7.  Verfahren für einen Drei-Pegel-Wechselrichter mit einem DC-Zwischenkreis, der durch einen Neutralpunkt in zwei Hälften geteilt ist, wobei das Verfahren umfasst
Ermitteln eines Spannungsrippels an dem Neutralpunkt,
**dadurch gekennzeichnet, dass** das Verfahren ferner umfasst
Ermitteln eines Realteils ($Re_{3h}$) einer dritten harmonischen Komponente des Spannungsrippels in einem rotierenden Koordinatensystem, das synchron mit einer Ausgangsspannung des Wechselrichters rotiert,
Berechnen einer Quadraturkomponente einer Ausgangsleistung in dem rotierenden Koordinatensystem, wobei das Ergebnis der Berechnung ein Produkt des Realteils der dritten harmonischen Komponente, einer Summe ($C_1 + C_2$) von die DC-Zwischenkreishälften bildenden Kapazitäten, einer Grundfrequenz ($\omega$) der Ausgangsspannung, einer DC-Zwischenkreisspannung ($U_{DC}$) und einer Konstanten ($-15\pi/16$) repräsentiert.

8.  Verfahren nach Anspruch 7, wobei eine Quadraturkomponente der Ausgangsleistung unter Anwendung der Gleichung berechnet wird:

$$Q = -\frac{15\pi}{32} U_{DC}\,\omega\left(C_1 + C_2\right)\mathrm{Re}_{3h}\left\{u_{C2} - u_{C1}\right\},$$

wobei $U_{DC}$ die DC-Zwischenkreisspannung ist, $\omega$ die Grundfrequenz der Ausgangsspannung ist, $C_1$ und $C_2$ die die DC-Zwischenkreishälften bildenden Kapazitäten sind, $\mathrm{Re}_{3h}$ eine Funktion für den Realteil der dritten Harmonischen ist, und der Spannungsrippel am Neutralpunkt $(u_{C2} - u_{C1})/2$ ist, wobei $u_{C1}$ und $u_{C2}$ die Spannungen an den Kapazitäten sind.

9. Vorrichtung für einen Drei-Pegel-Wechselrichter mit einem DC-Zwischenkreis, der durch einen Neutralpunkt in zwei Hälften geteilt ist, wobei die Vorrichtung eine Einrichtung zur Ausführung des Verfahrens nach einem der Ansprüche 1, 3, 5 oder 7 aufweist.

10. Wechselrichter mit einer Vorrichtung nach Anspruch 8.

**Revendications**

1. Procédé pour un onduleur à trois niveaux comprenant une liaison continue divisée en deux moitiés par un point de neutre, le procédé comprenant :

   la détermination d'une ondulation de tension au niveau du point de neutre,
   **caractérisé en ce que** le procédé comprend en outre :

      la détermination de la partie imaginaire de la composante de troisième harmonique ($\mathrm{Im}_{3h}$) de l'ondulation de tension dans un système de coordonnées tournantes qui tourne de manière synchrone avec la tension de sortie de l'onduleur,
      le calcul de la composante directe du courant de sortie dans le système de coordonnées tournantes, le résultat du calcul représentant le produit de la partie imaginaire de la composante de troisième harmonique ($\mathrm{Im}_{3h}$), de la somme ($C_1 + C_2$) des capacités formant les moitiés de liaison continue, de la fréquence fondamentale ($\omega$) de la tension de sortie, de la valeur réciproque de l'index de modulation ($M$) de l'onduleur et d'une constante ($15\pi/8$).

2. Procédé selon la revendication 1, dans lequel la composante directe du courant de sortie est calculée en utilisant l'équation :

$$I_d = \frac{15\pi}{16M}\,\omega\left(C_1 + C_2\right)\mathrm{Im}_{3h}\left\{u_{C2} - u_{C1}\right\},$$

où $\omega$ représente la fréquence fondamentale de la tension de sortie, M représente l'index de modulation, $C_1$ et $C_2$ sont les capacités formant les moitiés de liaison continue, $\mathrm{Im}_{3h}$ est une fonction pour la partie imaginaire de la troisième harmonique, et l'ondulation de tension au point de neutre vaut ($u_{C1}$ - $u_{C1}$) / 2, où $u_{C1}$ et $u_{C2}$ sont les tensions sur les capacités.

3. Procédé pour un onduleur à trois niveaux comprenant une liaison continue divisée en deux moitiés par un point de neutre, le procédé comprenant :

   la détermination de l'ondulation de tension au niveau du point de neutre,
   **caractérisé en ce que** le procédé comprend en outre :

      la détermination de la partie imaginaire de la composante de troisième harmonique ($\mathrm{Im}_{3h}$) de l'ondulation de tension dans un système de coordonnées tournantes qui tourne de manière synchrone avec la tension de sortie de l'onduleur,
      le calcul de la composante directe de la puissance de sortie dans le système de coordonnées tournantes, le résultat du calcul représentant le produit de la partie imaginaire de la composante de troisième harmonique ($\mathrm{Im}_{3h}$), de la somme ($C_1 + C_2$) des capacités formant les moitiés de liaison continue, de la fréquence fondamentale ($\omega$) de la tension de sortie, d'une tension de liaison continue ($U_{DC}$) et d'une constante ($45\pi/32$).

**4.** Procédé selon la revendication 3, dans lequel la composante directe de la puissance de sortie est calculée en utilisant l'équation :

$$P = \frac{45\pi}{64} U_{DC}\,\omega\left(C_1 + C_2\right)\mathrm{Im}_{3h}\left\{u_{C2} - u_{C1}\right\},$$

où $U_{DC}$ représente la tension de liaison continue, $\omega$ représente la fréquence fondamentale de la tension de sortie, $C_1$ et $C_2$ sont les capacités formant les moitiés de liaison continue, $\mathrm{Im}_{3h}$ est une fonction pour la partie imaginaire de la troisième harmonique, et où l'ondulation de tension au point de neutre vaut ($u_{C1}$ - $u_{C1}$) / 2, où $u_{C1}$ et $u_{C2}$ sont les tensions sur les capacités.

**5.** Procédé pour un onduleur à trois niveaux comprenant une liaison continue divisée en deux moitiés par un point de neutre, le procédé comprenant :

la détermination de l'ondulation de tension au point de neutre,
**caractérisé en ce que** le procédé comprend en outre :

la détermination de la partie réelle (Re$_{3h}$) de la composante de troisième harmonique de l'ondulation de tension dans un système de coordonnées tournantes qui tourne de manière synchrone avec la tension de sortie de l'onduleur,
le calcul de la composante en quadrature du courant de sortie dans le système de coordonnées tournantes, le résultat du calcul représentant le produit de la partie réelle de la composante de troisième harmonique, de la somme ($C_1$ + $C_2$) des capacités formant les moitiés de liaison continue, de la fréquence fondamentale ($\omega$) de la tension de sortie, de la valeur réciproque de l'index de modulation (M) de l'onduleur et d'une constante (-5$\pi$/4).

**6.** Procédé selon la revendication 5, dans lequel la composante en quadrature du courant de sortie est calculée en utilisant l'équation :

$$I_q = -\frac{5\pi}{8M}\,\omega\left(C_1 + C_2\right)\mathrm{Re}_{3h}\left\{u_{C2} - u_{C1}\right\},$$

où $\omega$ représente la fréquence fondamentale de la tension de sortie, M représente l'index de modulation, $C_1$ et $C_2$ sont les capacités formant les moitiés de liaison continue, Re$_{3h}$ est une fonction de la partie réelle de la troisième harmonique et l'ondulation de tension au point de neutre vaut ($u_{C2}$ - $u_{C1}$) / 2, où $u_{C1}$ et $u_{C2}$ sont les tensions sur les capacités.

**7.** Procédé pour un onduleur à trois niveaux comprenant une liaison continue divisée en deux moitiés par un point de neutre, le procédé comprenant :

la détermination de l'ondulation de tension au point de neutre,
**caractérisé en ce que** le procédé comprend en outre :

la détermination de la partie réelle (Re$_{3h}$) de la composante de troisième harmonique de l'ondulation de tension dans un système de coordonnées tournantes qui tourne de manière synchrone avec la tension de sortie de l'onduleur,
le calcul de la composante en quadrature de la puissance de sortie dans le système de coordonnées tournantes, le résultat du calcul représentant le produit de la partie réelle de la composante de troisième harmonique, de la somme ($C_1$ + $C_2$) des capacités formant les moitiés de liaison continue, de la fréquence fondamentale ($\omega$) de la tension de sortie, de la tension de liaison continue ($U_{DC}$) et d'une constante (-15$\pi$/16).

**8.** Procédé selon la revendication 7, dans lequel la composante en quadrature de la puissance de sortie est calculée en utilisant l'équation :

$$Q = -\frac{15\pi}{32} U_{DC} \omega \left( C_1 + C_2 \right) \mathrm{Re}_{3h} \left\{ u_{C2} - u_{C1} \right\},$$

où $U_{DC}$ représente la tension de liaison continue, $\omega$ représente la fréquence fondamentale de la tension de sortie, $C_1$ et $C_2$ sont les capacités formant les moitiés de liaison continue, $\mathrm{Re}_{3h}$ est une fonction de la partie réelle de la troisième harmonique et où l'ondulation de tension au point de neutre vaut ($u_{C2}$ - $u_{C1}$) / 2, où $u_{C1}$ et $u_{C2}$ sont les tensions sur les capacités.

9. Dispositif pour un onduleur à trois niveaux comprenant une liaison continue qui est divisée en deux moitiés par un point de neutre, le dispositif comprenant un moyen destiné à exécuter le procédé conformément à l'une quelconque des revendications 1, 3, 5 ou 7.

10. Onduleur comprenant un dispositif conforme à la revendication 8.

Figure 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 20092011248 A
- WO 2011048457 A1